(19) Europäisches Patentamt
European Patent Office
Office européen des brevets

(11) **EP 4 549 962 A1**

(12) **EUROPÄISCHE PATENTANMELDUNG**

(43) Veröffentlichungstag:
07.05.2025 Patentblatt 2025/19

(21) Anmeldenummer: 24208118.0

(22) Anmeldetag: 22.10.2024

(51) Internationale Patentklassifikation (IPC):
*G01R 27/18* (2006.01)     *G01R 31/14* (2006.01)
*H01G 9/21* (2006.01)      *H01G 2/00* (2006.01)
*H01C 1/00* (2006.01)      *G05B 11/42* (2006.01)
*G05B 13/02* (2006.01)     *H01C 10/14* (2006.01)
*H01C 10/00* (2006.01)     *H01C 10/50* (2006.01)

(52) Gemeinsame Patentklassifikation (CPC):
**G01R 27/025; G01R 31/52; H01C 10/00;**
**H01C 10/14; H01C 10/50**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(30) Priorität: **31.10.2023 DE 102023130147**

(71) Anmelder: **Bender GmbH & Co. KG**
**35305 Grünberg (DE)**

(72) Erfinder: **REITZ, Julian**
**35305 Grünberg (DE)**

(74) Vertreter: **advotec.**
**Patent- und Rechtsanwaltspartnerschaft Tappe mbB**
**Georg-Schlosser-Straße 6**
**35390 Gießen (DE)**

(54) **VERFAHREN ZUR ISOLATIONSÜBERWACHUNG UND ISOLATIONSÜBERWACHUNGSGERÄT MIT NETZSYMMETRIERUNG IN EINEM UNGEERDETEN GLEICHSPANNUNGSNETZ**

(57)     Die Erfindung betrifft ein Verfahren und ein Isolationsüberwachungsgerät zur Isolationsüberwachung mit Netzsymmetrierung in einem ungeerdeten Gleichspannungsnetz, mit einer Messung von Leiter-Erde-Spannungen mittels Spannungsmesseinrichtungen, einer leiterselektiven Berechnung von Isolationswiderständen und einem Ausregeln einer Spannungsasymmetrie zwischen den Leiter-Erde-Spannungen mittels eines Regelkreises. Die Erfindung umfasst eine Kombination aus Isolationsüberwachungsfunktion und Netzsymmetrierung basierend auf einem digitalen Regelkreis mit dem Maß der Asymmetrie (Asymmetriefaktor) als Regelgröße. Die Spannungsasymmetrie wird durch geeignete Bewertung einer (Spannungs-)Regelabeichung mittels eines Reglers permanent ausgeregelt und der dazu erforderliche Widerstands-Einstellwert als Stellgröße für einen der Stellwiderstände ermittelt.

Fig. 1

**Beschreibung**

Die Erfindung betrifft ein Verfahren zur Isolationsüberwachung mit Netzsymmetrierung in einem ungeerdeten Gleichspannungsnetz mit zwei aktiven Leitern, mit einer Messung von Leiter-Erde-Spannungen jeweils zwischen einem der aktiven Leiter und Erde mittels Spannungsmesseinrichtungen, einer leiterselektiven Berechnung von Isolationswiderständen nach Vorgaben der Norm IEC 61557-8 und einem Ausregeln einer Spannungsasymmetrie zwischen den Leiter-Erde-Spannungen mittels eines Regelkreises.

Weiter betrifft die Erfindung ein Isolationsüberwachungsgerät mit Netzsymmetrierung zum Betrieb in einem ungeerdeten Gleichspannungsnetz mit zwei aktiven Leitern, mit Spannungsmesseinrichtungen zum Messen von Leiter-Erde-Spannungen jeweils zwischen einem der aktiven Leiter und Erde und mit einer der Norm IEC 61557-8 entsprechenden Isolationsüberwachungsfunktion mit leiterselektivem Berechnen von Isolationswiderständen und mit einem Regelkreis zur Ausregelung einer Spannungsasymmetrie zwischen den Leiter-Erde-Spannungen.

Bei erhöhten Anforderungen an die Betriebs-, Brand- und Berührungssicherheit elektrischer Anlagen kommt die Netzform eines ungeerdeten Stromversorgungssystems zum Einsatz, die auch als isoliertes Netz (isolé terre - IT) oder als IT-(Stromversorgungs-)System bezeichnet wird. Bei dieser Art des Stromversorgungssystems sind die aktiven Teile von dem Erdpotential - gegenüber Erde - getrennt. Der Vorteil dieser Netze liegt darin, dass bei einem Isolationsfehler, wie beispielsweise einem Erdschluss oder einem Körperschluss, die Funktion der angeschlossenen elektrischen Verbraucher nicht beeinträchtigt wird, da sich wegen des im Idealfall unendlich großen Impedanzwertes zwischen einem aktiven Leiter des Netzes und Erde kein geschlossener Stromkreis ausbilden kann.

Durch diese inhärente Sicherheit des ungeerdeten Stromversorgungssystems kann somit eine kontinuierliche Stromversorgung der von dem ungeerdeten Stromversorgungssystem gespeisten Verbraucher auch dann gewährleistet werden, wenn ein erster Isolationsfehler auftritt.

Der Widerstand des ungeerdeten Stromversorgungssystems gegen Erde (Isolationswiderstand - im Fehlerfall auch Isolationsfehlerwiderstand oder Fehlerwiderstand) wird daher ständig überwacht, da durch einen möglichen weiteren Fehler an einem anderen aktiven Leiter eine Fehlerschleife entstünde und der dabei fließende Fehlerstrom in Verbindung mit einer Überstromschutzeinrichtung eine Abschaltung der Anlage mit Betriebsstillstand zur Folge hätte.

Zur Gewährleistung der elektrischen Sicherheit im Hinblick auf die Überwachung des Isolationswiderstands werden Isolationsüberwachungsgeräte eingesetzt. Aus dem Stand der Technik bekannte Isolationsüberwachungsgeräte nach der Produktnorm IEC 61557-8 bestimmen den Isolationswiderstand des gesamten IT-Systems gegen Erde. Ein derartiges Isolationsüberwachungsgerät wird zwischen den aktiven Leitern einerseits und Erde andererseits angeschlossen und überlagert dem Netz eine Messspannung (aktives Messverfahren). Bei Auftreten eines Isolationsfehlers schließt sich der Messkreis zwischen Netz und Erde über den Isolationsfehler, sodass sich ein dem Isolationsfehler proportionaler Messstrom einstellt. Dieser Messstrom verursacht an einem Messwiderstand in dem Isolationsüberwachungsgerät einen entsprechenden Spannungsabfall, der von der Elektronik ausgewertet wird und bei Überschreiten eines voreinstellbaren Grenzwertes zu einer Alarmmeldung führt.

Der Norm IEC 61557-8 entsprechende Isolationsüberwachungsgeräte sind somit in der Lage, kritische Anlagenzustände, wie ein zu niedriges Isolationsniveau, insbesondere auch bei Vorliegen symmetrischer Isolationsfehler, oder zu hohe Erdkapazitätswerte zu erkennen, zu melden und gegebenenfalls die Abschaltung eines fehlerhaften Leitungszweiges herbeizuführen.

Passiv arbeitende, nicht den Vorgaben der Norm IEC 61557-8 entsprechende Verfahren zur Messung des Isolationswiderstands hingegen kommen ohne aktive Strom- oder Spannungsquellen aus und basieren darauf, dass die Impedanz der Leiter-Erde-Pfade durch das Zu- und Abschalten oder die Variation einer oder zweier künstlich eingeprägter Leiter-Erde-Impedanzen und deren Auswirkung auf die Leiter-Erde-Spannungen erfasst und bewertet wird. Ein Beispiel dazu ist das 3-Voltmeter-Verfahren, wobei wechselnd ein Einfügewiderstand zwischen dem positiven aktiven Leiter und Erde sowie dem negativen Leiter und Erde geschaltet wird. Die Auswertung der Spannungsmessungen führt dann zu den gesuchten Isolationswiderstandswerten.

Ebenso kann die Symmetrie der Netzspannung als Überwachungs- und Meldegröße verwendet werden. Die Symmetrie der Netzspannung spielt in Verbindung mit natürlichen und vor allem künstlichen Erdableitkapazitäten in ungeerdeten Gleichspannungsnetzen eine herausragende Rolle.

Gemäß der Gesetzmäßigkeit $E = \frac{1}{2} \cdot C \cdot U^2$ steigt die Energiemenge, welche in einer (Erdableit-)Kapazität C enthalten sein kann, mit der Spannung quadratisch an. Liegt eine vollständige Asymmetrie der aktiven Leiter gepaart mit einer simultanen Verdopplung der Leiter-Erde-Spannung vor, so kann für Menschen und Sachwerte eine deutlich erhöhte Gefährdung bei Berührung aktiver Leiter bestehen.

Aus dem Stand der Technik sind nun Lösungen bekannt, um die in dem Stromversorgungssystem gespeicherte Energie zu begrenzen und damit das Gefährdungspotential zu reduzieren.

Grundsätzlich besteht die Möglichkeit, die Kapazitäten zu reduzieren bzw. nach einem Worst-Case zu dimensionieren. Die Energiebegrenzung von Erdableitkapazitäten in ungeerdeten Stromnetzen kann durch anwendungsspezifische Vorgaben zur Größe des zulässigen Kapazitätswertes bewerkstelligt werden. Dies ist jedoch je nach Größe und Ausdehnung des ungeerdeten Stromversorgungssystems nicht immer möglich.

Alternativ und auf Grund des quadratischen Einflusses der Spannung auf die aufgenommene Energie deutlich effizienter ist eine passive oder aktive Symmetrierung der Leiter-Erde-Spannung.

Als passive Lösung bietet sich hierzu ein symmetrischer Spannungsteiler mit Erdpotential in der Mitte an. Da die verwendeten Widerstände, welche permanent im System verbleiben, nicht hinreichend niederohmig gestaltet werden können, stellt diese Methode keine ernsthafte Lösung für asymmetrische Absenkungen des Isolationswiderstands dar.

Aktive Verfahren dagegen können die Spannungsasymmetrie auswerten und entsprechend darauf reagieren.

In der Offenlegungsschrift WO2023007253A1 ist ein netzsymmetrierendes Isolationsüberwachungsgerät mit aktiver Spannungsunsymmetrie-Korrektur offenbart. Dabei werden analog steuerbare Spannungs- und Stromquellenschaltungen eingesetzt, die jedoch zu einer äußerst aufwendigen Schaltungsarchitektur führen.

Ein weiteres Verfahren ist in der Offenlegungsschrift DE102020006919A1 beschrieben. Hier werden zum Ausgleich etwaiger Spannungsschieflasten in einem Hochvoltsystem eines Fahrzeugs diskrete Widerstandswerte zwischen die aktiven Leiter und Erde zu- oder abgeschaltet.

Die Patentschrift DE102018116055B3 zeigt ein Verfahren und Isolationswächter zur widerstandsadaptiven Isolierungsüberwachung. Das Verfahren beruht im Kern auf der 3-Voltmeter-Methode, wobei zwei Arbeitspunkte betrachtet werden, in denen keine diskreten Widerstände umgeschaltet werden, sondern eine Kombination aus Halbleiterschalter und Widerstand zu einem, über eine gewisse Integrationszeit beständigen, Ankoppelwiderstand moduliert wird. Damit wird gleichermaßen das Gleichspannungsnetz symmetriert, was den Energiegehalt in den Ableitkapazitäten im Verhältnis zu einer vollständigen Asymmetrie reduziert. Ob die Herstellung einer vollständigen Symmetrie erreichbar ist, erscheint jedoch fraglich, da für die ebenfalls beschriebene Anwendung des 3-Voltmeter-Verfahrens mindestens zwei Arbeitspunkte benötigt werden. Wenn allerdings die Leiter-Erde-Spannungen stets symmetrisch sind, so existiert kein zweiter Arbeitspunkt, eine absolute Bestimmung beider, leiterbezogenen, Isolationswiderstände ist so nicht möglich.

Der vorliegenden Erfindung liegt somit die Aufgabe zu Grunde, ein Verfahren und ein das Verfahren umsetzendes Isolationsüberwachungsgerät zu entwickeln, welche in einem ungeerdeten Gleichspannungsnetz sowohl eine robuste Netzsymmetrierung als auch eine normgemäße Isolationswiderstandsüberwachung Bauteil-effizient und damit kostengünstig ausführen.

Diese Aufgabe wird bezogen auf ein Verfahren in Verbindung mit den Merkmalen des Oberbegriffs des Anspruchs 1 dadurch gelöst, dass das Ausregeln der Spannungsasymmetrie durch eine digitale Regelung erfolgt, wobei mit einem vorgegebenen Asymmetriefaktor eine Leiter-Leiter-Spannung multipliziert wird, um eine gewichtete Leiter-Leiter-Spannung als Führungsgröße zu erzeugen; Subtrahieren einer der Leiter-Erde-Spannungen von der gewichteten Leiter-Leiter-Spannung zum Ermitteln einer Regelabweichung; Berechnen eines Widerstands-Einstellwerts als Stellgröße aus der Regelabweichung mittels eines in einem Regler implementierten zeitdiskreten Regelalgorithmus; Einstellen von einem der jeweils zwischen einem der aktiven Leiter und Erde angeordneten Stellwiderstände mittels der Stellgröße so, dass die Spannungssymmetrie der Leiter-Erde-Spannungen kontinuierlich ausgeregelt wird, und Berechnen der leiterbezogenen Isolationswiderstände aus den sich in Abhängigkeit des Asymmetriefaktors einstellenden Stellwiderständen bei zwei vorgegebenen unterschiedlichen Asymmetriefaktoren.

Die vorliegende Erfindung umfasst somit eine Kombination aus Isolationsüberwachungsfunktion und Netzsymmetrierung basierend auf einem digitalen Regelkreis mit dem Maß der Asymmetrie (Asymmetriefaktor) als Regelgröße. Die Spannungsasymmetrie wird durch geeignete Bewertung einer (Spannungs-)Regelabeichung mittels eines Reglers permanent ausgeregelt und der dazu erforderliche Widerstands-Einstellwert als Stellgröße für einen der Stellwiderstände ermittelt.

Dazu wird ein vorgegebener Asymmetriefaktor mit der Leiter-Leiter-Spannung multipliziert, um eine gewichtete Leiter-Leiter-Spannung als Führungsgröße zu erzeugen. Aus der Differenz zwischen der gewichteten Leiter-Leiter-Spannung und einer der Leiter-Erde-Spannungen ergibt sich die Regelabweichung, welche einem digitalen Regler zugeführt wird, der einen Widerstands-Einstellwert als Stellgröße zum Einstellen von einem der jeweils zwischen einem der aktiven Leiter und Erde geschalteten Stellwiderstände berechnet. Die Berechnung der leiterbezogenen Isolationswiderstände erfolgt dann aus den sich einstellenden Stellwiderständen bei zwei durch zwei unterschiedliche Asymmetriefaktoren vorgegebenen Arbeitspunkten. In Abgrenzung zum Stand der Technik wird damit zur Isolationsüberwachung eine Regelgröße zur Berechnung des Isolationswiderstands verwendet.

Mit dem erfindungsgemäßen Verfahren werden sowohl die Netzsymmetrierung als auch die Isolationsüberwachung in ungeerdeten Gleichspannungsstromnetzen realisiert und entgegen bekannten messtechnischen Ausführungen dem Maß der Asymmetrie der Leiter-Erde-Spannungen verfahrensbedingt oberste Priorität eingeräumt.

Das Verfahren ist robust gegen Änderungen der Betriebsspannung (Nennspannung), da nicht auf die Leiter-Erde-Spannungen als solche, sondern auf deren Verhältnis, also das Maß der Asymmetrie, geregelt wird.

In weiterer Ausgestaltung führt der Regler einen zeitdiskreten PID-Regelalgorithmus aus.

Um neben dem stationären Verhalten (PI-Anteil) auch das dynamische Verhalten (PD-Anteil) der Regelung beeinflussen zu können, gelangt vorzugsweise ein PID-Regelalgorithmus zum Einsatz.

Das Verfahren ist daher in der Lage, besonders schnell auf plötzlich auftretende, sprunghafte Asymmetrien zu reagieren, da die durch den PID-Regler verstärkten Regelabweichungen zügig ausgeglichen werden.

Weiter wird mittels einer Signalweiche abhängig von der Polarität der Regelabweichung einer der Stellwiderstände durch die Stellgröße angesteuert.

Um den gewünschten Regeleffekt zu erreichen, wird je nach Polarität nur einer der beiden Stellwiderstände angesteuert. Dies wird mittels der polaritätsabhängigen Signalweiche realisiert.

Bevorzugt wird die Stellgröße mittels einer Sättigungseinrichtung begrenzt, sodass der jeweilige Stellwiderstand höchstens einen maximalen Widerstandswert annehmen kann.

Theoretisch könnte der jeweilige Stellwiderstand auch den Wert unendlich annehmen, jedoch macht es aus regelungstechnischer Sicht Sinn, die Auslenkung der Stellgröße auf einen maximalen Widerstandswert zu begrenzen.

Weiterhin erfolgt das Einstellen des Stellwiderstands derart, dass als Stellwiderstand ein elektromechanisches Potentiometer mit Antrieb, ein schaltbarer Festwiderstand, ein PWM-gesteuerter Halbleiterschalter oder eine analog geregelte Widerstandsnachbildung mit Transistoren angesteuert wird.

Diese Ausführungsarten der Stellwiderstände erlauben eine verzögerungsfreie und genaue Einstellbarkeit der gewünschten Widerstandswerte.

Bevorzugt wird die Leiter-Leiter-Spannung durch Addition der Leiter-Erde-Spannungen berechnet oder die Leiter-Leiter-Spannung wird direkt gemessen.

Neben der Möglichkeit, die Leiter-Leiter-Spannung aus der Addition der durch Einzelmessungen gewonnen Leiter-Erde-Spannungen zu berechnen kann die Leiter-Leiter-Spannung auch direkt durch Messung ermittelt werden. Die Messung einer der Leiter-Erde-Spannungen würde dann entfallen.

Weiter werden die zwei (zur Berechnung der leiterbezogenen Isolationswiderstände erforderlichen) vorgegebenen unterschiedlichen Asymmetriefaktoren durch zyklisches Umschalten symmetrisch um den Symmetriepunkt aktiviert, wobei die Umschaltzeitpunkte in Abhängigkeit der Regelabweichung steuerbar sind.

Um die Funktion der Isolationsüberwachung mit Berechnung der leiterselektiven Isolationswiderstände zu erfüllen, wird die erfindungsgemäße Regelung der Netzsymmetrierung um weitere Elemente erweitert. Würde permanent auf Netzsymmetrie, also auf den Asymmetriefaktor mit dem Wert 0.5 (Symmetriepunkt), ausgeregelt, so wäre die messtechnische Aufgabe nicht lösbar. Man könnte zwar das Verhältnis der Isolationswiderstände (positiver/negativer Leiter gegen Erde) angeben, jedoch nicht deren Absolutwerte. Zur Lösung eines linearen Gleichungssystems sind daher zwei Arbeitspunkte erforderlich. Diese werden erzeugt, indem man leichte Asymmetrien, also zwei von dem Symmetriepunkt abweichende Asymmetriefaktoren, zulässt und zwischen diesen zyklisch in Intervallen um den Symmetriepunkt umschaltet.

Die in Anspruch 8 und in den auf Anspruch 8 rückbezogenen Ansprüchen aufgeführten strukturellen Merkmale des erfindungsgemäßen Isolationsüberwachungsgerätes mit Netzsymmetrierung führen die entsprechenden Verfahrensschritte des erfindungsgemäßen Verfahrens aus. Somit treffen die mit dem Verfahren erzielten technischen Wirkungen und die daraus resultierenden Vorteile gleichermaßen auch auf das erfindungsgemäße Isolationsüberwachungsgerät mit Netzsymmetrierung zu.

Insbesondere stellt es sich als Vorteil heraus, dass das erfindungsgemäße Isolationsüberwachungsgerät mit Netzsymmetrierung mit sehr wenigen externen Bauteilen, also zwei Spannungsmesseinrichtungen und zwei Stellwiderständen auskommt.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:

**Fig. 1:** ein funktionales Blockschaltbild des erfindungsgemäßen Isolationsüberwachungsgerätes mit Netzsymmetrierung,

**Fig. 2:** einen simulierten Verlauf der Leiter-Erde-Spannungen und einen Verlauf des Verhältnisses der Asymmetriefaktoren bei einem Sprung des Isolationswiderstands Rf- , und

**Fig. 3:** einen simulierten Verlauf der Leiter-Erde-Spannungen und einen Verlauf des Verhältnisses der Asymmetriefaktoren bei einem Sprung des Isolationswiderstands Rf+.

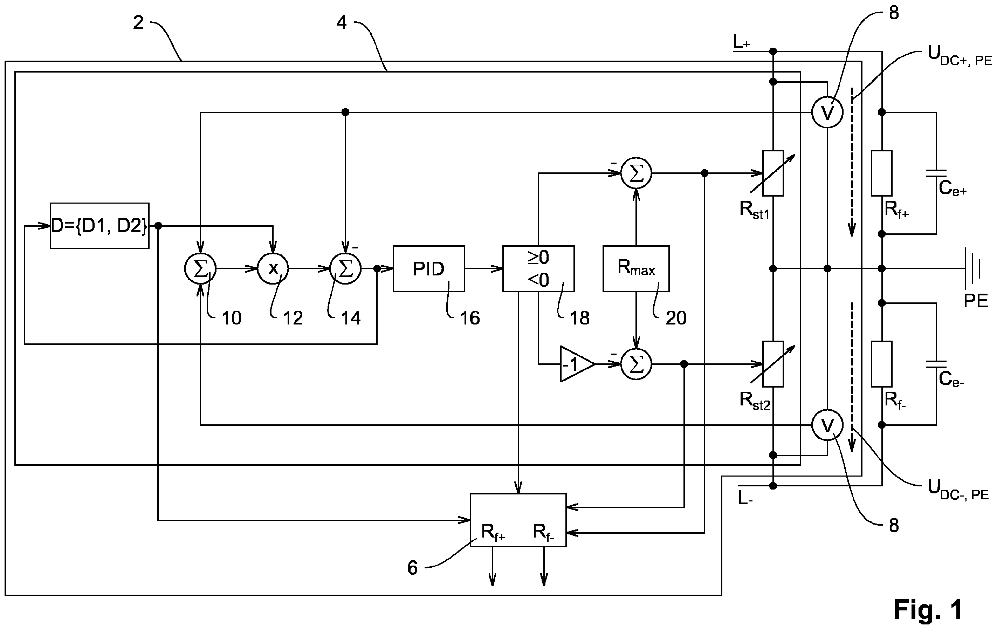

In **Fig. 1** ist ein funktionales Blockschaltbild des erfindungsgemäßen Verfahrens durch ein dieses Verfahren umsetzendes, erfindungsgemäßes Isolationsüberwachungsgerät 2 dargestellt. Das Isolationsüberwachungsgerät 2 ist in einem ungeerdeten Gleichspannungsnetz mit zwei aktiven Leitern L+, L_ installiert. Jeweils zwischen einem der aktiven Leiter L+, L_ und Erde PE sind die zu überwachenden Isolationswiderstände $R_{f+}$, $R_{f-}$ und die unvermeidbaren Ableitkapazitäten $C_{e+}$, $C_{e-}$ des ungeerdeten Gleichspannungsnetzes dargestellt.

Kernelemente des Isolationsüberwachungsgerätes 2 bilden ein als digitale Regelung implementierter Regelkreis 4 zur Herstellung der Symmetrie zwischen den Leiter-Erde-Spannungen $U_{DC+, PE}$, $U_{DC-, PE}$ sowie eine Isolationsüberwachungsfunktion 6 zur leiterselektiven Berechnung der Isolationswiderstände $R_{f+}$, $R_{f-}$.

Dazu werden beide Leiter-Erde-Spannungen $U_{DC+, PE}$, $U_{DC-, PE}$ mittels Spannungsmesseinrichtungen 8 gemessen und auf einen Addierer 10 geführt, welcher die Leiter-Leiter-Spannung $U_{DC+, DC-}$ ermittelt. Eine Analog-Digital-Umsetzung der gemessenen Größen wird dabei implizit angenommen und ist nicht dargestellt.

Mit einem vorgegebenen Asymmetriefaktor D wird die Leiter-Leiter-Spannung $U_{DC+, DC-}$ folgend multipliziert, woraus sich am Ausgang eines Multiplizierers 12 eine gewichtete Leiter-Leiter-Spannung als eigentliche Führungsgröße w(t) der Regelung ergibt.

Nachfolgend wird durch einen Subtrahierer 14 aus der mit dem Asymmetriefaktor D gewichteten Leiter-Leiter-Spannung $U_{DC+, DC-}$ und einer der Leiter-Erde-Spannungen, hier $U_{DC+, PE}$, eine Regelabweichung e(t) ermittelt und auf einen Regler 16 geführt.

Der Regler 16 berechnet aus der Regelabweichung e(t) mittels zeitdiskretem PID-Regelalgorithmus einen Widerstands-Einstellwert als Stellgröße u(t) zur Einstellung von einem der jeweils zwischen einem der aktiven Leiter L+, L_ und Erde PE angeordneten Stellwiderstände $R_{st1}$, $R_{st2}$.

Eine polaritätsabhängige Signalweiche 18 entscheidet dabei in Abhängigkeit der Polarität der Regelabweichung e(t), welcher der Stellwiderstände $R_{st1}$, $R_{st2}$ durch die Stellgröße u(t) angesteuert wird.

Der Regelkreis 4 weist weiter eine Sättigungseinrichtung 20 auf, sodass der jeweilige Stellwiderstand $R_{st1}$, $R_{st2}$ höchstens einen maximalen Widerstandswert $R_{max}$ annehmen kann.

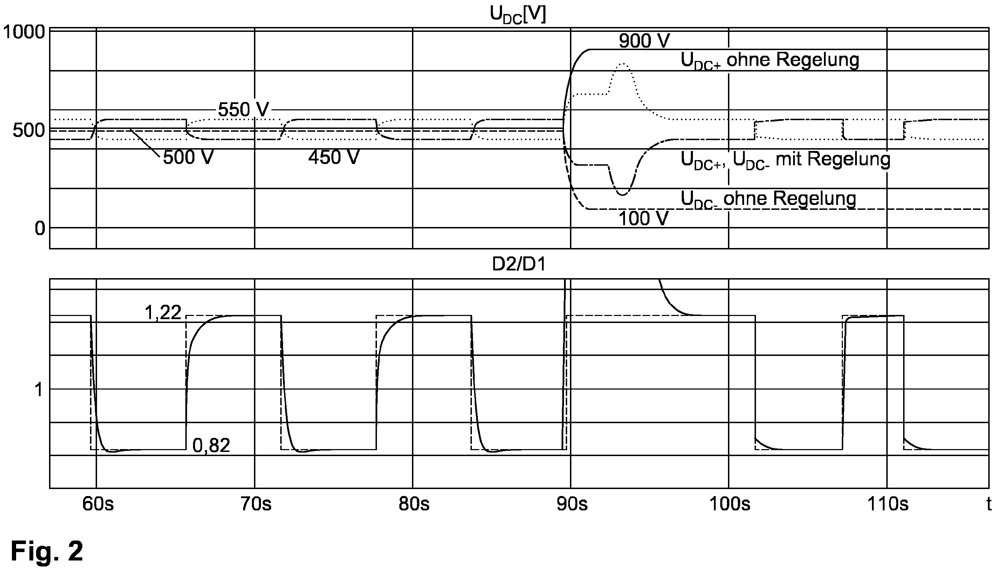

**Fig. 2** zeigt als Simulationsergebnis einen Verlauf der Leiter-Erde-Spannungen $U_{DC+, PE}$, $U_{DC-, PE}$ und einen Verlauf des Verhältnisses der Asymmetriefaktoren $D_1$, $D_2$ bei einem Sprung des Isolationswiderstands Rf_ von 200kΩ auf 20kΩ.

Ohne Regelung der Netzsymmetrie entsprechen die Leiter-Erde-Spannungen $U_{DC+, PE}$, $U_{DC-, PE}$ zunächst der Nennspannung von 500V, da sich das Gleichspannungsnetz mit $R_{f+}=R_{f-}=200kΩ$ in symmetrischem Zustand befindet. Nach einem die Unsymmetrie erzeugenden Sprung des Isolationswiderstands $R_{f-}$ von 200kΩ auf 20kΩ ändern sich die Leiter-Erde-Spannungen auf $U_{DC+, PE}=900V$ bzw. $U_{DC-, PE}=100V$.

Mit der erfindungsgemäßen Regelung wird der Asymmetriefaktor D={$D_1$, $D_2$} zyklisch zwischen den zwei Werten $D_1=0.45$ und $D_2=0.55$ umgeschaltet, um mit dieser bewusst zugelassenen leichten Unsymmetrie die zwei erforderlichen Arbeitspunkte für die Berechnung der Isolationswiderstände zu generieren. Das Gleichspannungsnetz ist zunächst mit $R_{f+}=R_{f-}=200kΩ$ in symmetrischem Zustand und die Leiter-Erde-Spannungen $U_{DC+, PE}$, $U_{DC-, PE}$ verlaufen - aufgrund der leichten "symmetrischen" Unsymmetrie - symmetrisch und alternierend um die Nennspannung von 500V mit Werten von 550V und 450V. Nach dem Sprung des Isolationswiderstands $R_{f-}$ von 200kΩ auf 20kΩ - der Isolationswiderstand $R_{f+}=200kΩ$ bleibt unverändert - wird die durch den Sprung bedingte Unsymmetrie nach einer kurzen Übergangsphase ausgeregelt und die Ausgangswerte der Leiter-Erde-Spannungen $U_{DC+, PE}$, $U_{DC-, PE}$ von 450V und 550V stellen sich wieder ein.

Die untere Darstellung gibt den entsprechenden Verlauf des Verhältnisses der Asymmetriefaktoren $D_2/D_1$ wieder. Dieses beträgt mit der bewusst eingestellten leichten Unsymmetrie alternierend 0.55/0.45=1.22 bzw. 0.45/0.55=0.82 und wird auch nach der durch den Sprung des Isolationswiderstands $R_{f-}$ von 200kΩ auf 20kΩ verursachten Unsymmetrie wieder auf diese Werte ausgeregelt.

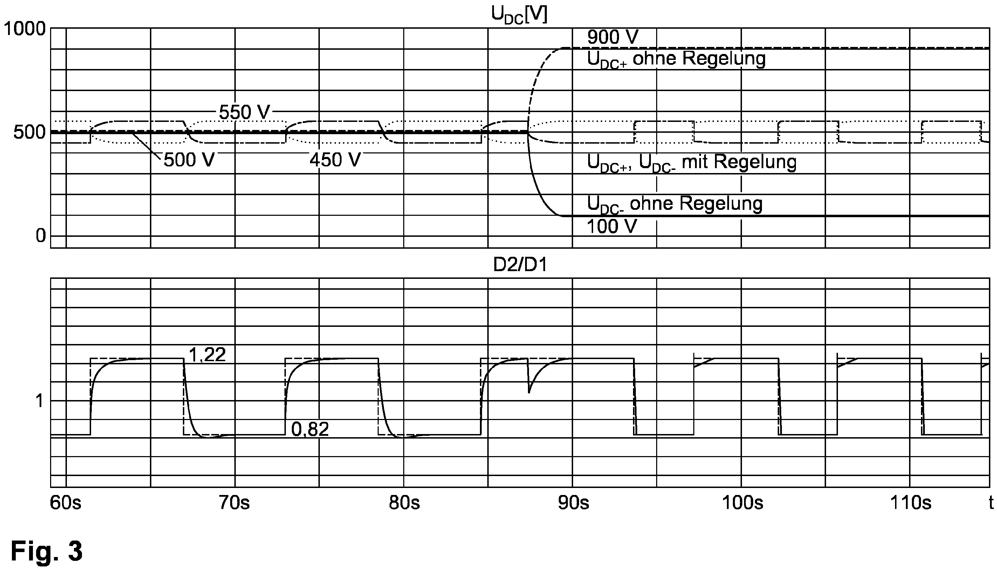

**Fig. 3** zeigt die Simulationsergebnisse analog zu Fig. 2 für einen Sprung des Isolationswiderstands $R_{f+}$ von 200kΩ auf 20kΩ - der Isolationswiderstand $R_{f-}=200kΩ$ bleibt unverändert. Auch hier ist zu erkennen, dass die Leiter-Erde-Spannungen $U_{DC+, PE}$, $U_{DC-, PE}$ (obere Darstellung) ebenso wie das Verhältnis der Asymmetriefaktoren $D_2/D_1$ (untere Darstellung) auf ihre anfänglichen Werte ausgeregelt werden.

In den dargestellten Simulationsergebnissen erfolgt die zyklische Umschaltung mit einer festgelegten Periode. In der Praxis jedoch folgt die Umschaltung nicht nach einem festen zeitlichem Ablauf, sondern basiert auf der Auswertung der Regelabweichung e(t). Nach dem Umschalten des Asymmetriefaktors D={$D_1$, $D_2$} wird zunächst ein festes Zeitintervall, z.B. T=1s, abgewartet. Dann findet so lange keine Aktion statt, bis die Regelabweichung e(t) nahezu null beträgt. Ist dieser Zustand erreicht, so werden die Stellwiderstände $R_{st1}$(D), $R_{st2}$(D) der Berechnung der leiterbezogenen Isolationswiderstände Rf+, Rf- zugeführt und der Asymmetriefaktor folgend gewechselt.

Die Berechnung der leiterbezogenen Isolationswiderstände Rf+, Rf- erfolgt ausgehend von den Stellwiderständen $R_{st1}$(D), $R_{st2}$(D), die sich in Abhängigkeit des momentanen und zyklisch wechselnden Asymmetriefaktors D={$D_1$, $D_2$} einstellen.

In die Berechnung geht ebenfalls die Information aus der Signalweiche 18 ein, also welcher der beiden Stellwiderstände $R_{st1}$, $R_{st2}$ genutzt wird/aktiv ist. Dies ist erforderlich, da es für beide Fälle optimierte Gleichungen gibt, welche dann entsprechend genutzt werden sollten.

Für $R_{st1}$ aktiv gilt:

$$R_{f-} = \frac{D_2 - D_1}{-\dfrac{D_2}{R_{st2}(D_1)} + \dfrac{D_1 D_2}{R_{st1}(D_1)} + \dfrac{D_1}{R_{st2}(D_2)} + \dfrac{D_1 D_2}{R_{st1}(D_2)}}$$

$$R_{f+} = \cfrac{1}{\cfrac{\cfrac{1}{R_{f-}} + \cfrac{1}{R_{st2}(D_1)}}{D_1} - \cfrac{1}{R_{st1}(D_1)}}$$

Für $R_{st2}$ aktiv gilt:

$$R_{f+} = \cfrac{D_2 - D_1}{\cfrac{D_1 - D_2}{R_{st1}(D_1)} - \cfrac{1}{R_{st2}(D_1)} + \cfrac{1}{R_{st2}(D_2)}}$$

$$R_{f-} = \cfrac{1}{D_2\left(\cfrac{1}{R_{f+}} + \cfrac{1}{R_{st1}(D_2)}\right) - \cfrac{1}{R_{st2}(D_2)}}$$

In vorteilhafter Weise kann anwendungsspezifisch festgelegt werden, welcher Grad an Asymmetrie zum Erfüllen der Isolationsüberwachungsfunktion zuzulassen ist. Ebenso wäre es möglich, die Isolationswiderstandsberechnung nur zu bestimmten Zeitpunkten zu realisieren und in der verbleibenden Zeit eine vollständige Netzsymmetrie - gänzlich ohne die zur Berechnung der Isolationswiderstände erforderliche leichte Unsymmetrie - anzuwenden. Auch ein dauerhaftes Abschalten der Isolationswiderstands-Messfunktion ist denkbar.

## Patentansprüche

1. Verfahren zur Isolationsüberwachung mit Netzsymmetrierung in einem ungeerdeten Gleichspannungsnetz mit zwei aktiven Leitern (L+, L_), umfassend die Verfahrensschritte:

   Messen von Leiter-Erde-Spannungen ($U_{DC+, PE}$, $U_{DC-, PE}$) jeweils zwischen einem der aktiven Leiter (L+, L_) und Erde (PE) mittels Spannungsmesseinrichtungen,
   leiterselektives Berechnen von Isolationswiderständen ($R_{f+}$, $R_{f-}$) nach Vorgaben der Norm IEC 61557-8,
   Ausregeln einer Spannungsasymmetrie zwischen den Leiter-Erde-Spannungen ($U_{DC+, PE}$, $U_{DC-, PE}$) mittels eines Regelkreises (4),
   **dadurch gekennzeichnet, dass**
   das Ausregeln der Spannungsasymmetrie durch eine digitale Regelung (4) erfolgt, wobei
   mit einem vorgegebenen Asymmetriefaktor (D) eine Leiter-Leiter-Spannung ($U_{DC+, DC-}$) multipliziert (12) wird, um eine gewichtete Leiter-Leiter-Spannung als Führungsgröße (w(t)) zu erzeugen;
   Subtrahieren (14) einer der Leiter-Erde-Spannungen ($U_{DC+, PE}$, $U_{DC-, PE}$) von der gewichteten Leiter-Leiter-Spannung (w(t)) zum Ermitteln einer Regelabweichung (e(t));
   Berechnen eines Widerstands-Einstellwerts als Stellgröße (u(t)) aus der Regelabweichung (e(t)) mittels eines in einem Regler (16) implementierten zeitdiskreten Regelalgorithmus;
   Einstellen von einem der jeweils zwischen einem der aktiven Leiter (L+, L_) und Erde (PE) angeordneten Stellwiderstände ($R_{st1}$, $R_{st2}$) mittels der Stellgröße (u(t)) so, dass die Spannungssymmetrie der Leiter-Erde-Spannungen ($U_{DC+, PE}$, $U_{DC-, PE}$) kontinuierlich ausgeregelt wird, und
   Berechnen der leiterbezogenen Isolationswiderstände (Rf+, Rf-) aus den sich in Abhängigkeit des Asymmetriefaktors (D) einstellenden Stellwiderständen ($R_{st1}$, $R_{st2}$) bei zwei vorgegebenen unterschiedlichen Asymmetriefaktoren ($D_1$, $D_2$).

2. Verfahren nach Anspruch 1,
   **dadurch gekennzeichnet,**
   **dass** der Regler (16) einen zeitdiskreten PID-Regelalgorithmus ausführt.

3. Verfahren nach Anspruch 1 oder 2,
   **dadurch gekennzeichnet,**
   **dass** mittels einer Signalweiche (18) abhängig von der Polarität der Regelabweichung (e(t)) einer der Stellwiderstände ($R_{st1}$, $R_{st2}$) durch die Stellgröße (u(t)) angesteuert wird.

4. Verfahren nach einem der Ansprüche 1 bis 3,
**dadurch gekennzeichnet,**
**dass** die Stellgröße ($u(t)$) mittels einer Sättigungseinrichtung (20) begrenzt wird, sodass der jeweilige Stellwiderstand ($R_{st1}$, $R_{st2}$) höchstens einen maximalen Widerstandswert ($R_{max}$) annehmen kann.

5. Verfahren nach einem der Ansprüche 1 bis 4,
**dadurch gekennzeichnet,**
**dass** das Einstellen des Stellwiderstands ($R_{st1}$, $R_{st2}$) derart erfolgt, dass als Stellwiderstand ($R_{st1}$, $R_{st2}$) ein elektromechanisches Potentiometer mit Antrieb, ein schaltbarer Festwiderstand, ein PWM-gesteuerter Halbleiterschalter oder eine analog geregelte Widerstandsnachbildung mit Transistoren angesteuert wird.

6. Verfahren nach einem der Ansprüche 1 bis 5,
**dadurch gekennzeichnet,**
**dass** die Leiter-Leiter-Spannung ($U_{DC+, DC-}$) durch Addition (10) der Leiter-Erde-Spannungen ($U_{DC+, PE}$, $U_{DC-, PE}$) berechnet wird oder die Leiter-Leiter-Spannung ($U_{DC+, DC-}$) direkt gemessen wird.

7. Verfahren nach einem der Ansprüche 1 bis 6,
**dadurch gekennzeichnet,**
**dass** die zwei vorgegebenen unterschiedlichen Asymmetriefaktoren ($D_1$, $D_2$) durch zyklisches Umschalten symmetrisch um den Symmetriepunkt aktiviert werden, wobei die Umschaltzeitpunkte in Abhängigkeit der Regelabweichung ($e(t)$) steuerbar sind.

8. Isolationsüberwachungsgerät mit Netzsymmetrierung zum Betrieb in einem ungeerdeten Gleichspannungsnetz mit zwei aktiven Leitern (L+, L_), umfassend

Spannungsmesseinrichtungen zum Messen von Leiter-Erde-Spannungen ($U_{DC+, PE}$, $U_{DC-, PE}$) jeweils zwischen einem der aktiven Leiter (L+, L_) und Erde (PE),
eine der Norm IEC 61557-8 entsprechende Isolationsüberwachungsfunktion mit leiterselektivem Berechnen von Isolationswiderständen (Rf+, Rf-) und mit einem Regelkreis (4) zur Ausregelung einer Spannungsasymmetrie zwischen den Leiter-Erde-Spannungen ($U_{DC+, PE}$, $U_{DC-, PE}$),
**dadurch gekennzeichnet,**
**dass** der Regelkreis als digitale Regelung (4) implementiert ist, die folgenden Funktionsblöcke umfasst:

einen Multiplizierer (12) zur Multiplikation eines vorgegebenen Asymmetriefaktors (D) mit einer Leiter-Leiter-Spannung ($U_{DC+, DC-}$) um eine gewichtete Leiter-Leiter-Spannung als Führungsgröße ($w(t)$) zu erzeugen;
einen Subtrahierer (14), der durch Subtraktion einer der Leiter-Erde-Spannungen ($U_{DC+, PE}$, $U_{DC-, PE}$) von der gewichteten Leiter-Leiter-Spannung ($w(t)$) eine Regelabweichung ($e(t)$) ermittelt;
einen Regler (16), der aus der Regelabweichung ($e(t)$) mittels zeitdiskretem Regelalgorithmus einen Widerstands-Einstellwert als Stellgröße ($u(t)$) berechnet;
jeweils einen zwischen einem der aktiven Leiter (L+, L_) und Erde (PE) angeordneten Stellwiderstand ($R_{st1}$, $R_{st2}$), welcher wahlweise durch die Stellgröße ($u(t)$) so eingestellt wird, dass die Spannungssymmetrie der Leiter-Erde-Spannungen ($U_{DC+, PE}$, $U_{DC-, PE}$) kontinuierlich ausgeregelt wird;
eine Isolationswiderstands-Berechnung zur Bestimmung der leiterbezogenen Isolationswiderstände (Rf+, Rf-) aus den sich in Abhängigkeit des Asymmetriefaktors (D) einstellenden Stellwiderständen ($R_{st1}$, $R_{st2}$) bei zwei vorgegebenen unterschiedlichen Asymmetriefaktoren ($D_1$, $D_2$).

9. Isolationsüberwachungsgerät mit Netzsymmetrierung nach Anspruch 8,
**dadurch gekennzeichnet,**
**dass** in dem Regler (16) ein zeitdiskreter PID-Regelalgorithmus implementiert ist.

10. Isolationsüberwachungsgerät mit Netzsymmetrierung nach Anspruch 8 oder 9,
**dadurch gekennzeichnet durch**
eine Signalweiche (18), die abhängig von der Polarität der Regelabweichung ($e(t)$) einen der Stellwiderstände ($R_{st1}$, $R_{st2}$) durch die Stellgröße ($u(t)$) ansteuert.

11. Isolationsüberwachungsgerät mit Netzsymmetrierung nach einem der Ansprüche 8 bis 10,
**gekennzeichnet durch**
eine Sättigungseinrichtung (20), welche die Stellgröße ($u(t)$) begrenzt, sodass der jeweilige Stellwiderstand ($R_{st1}$,

$R_{st2}$) höchstens einen maximalen Widerstandswert ($R_{max}$) annehmen kann.

12. Isolationsüberwachungsgerät mit Netzsymmetrierung nach einem der Ansprüche 8 bis 11,
**dadurch gekennzeichnet,**
**dass** die Stellwiderstände ($R_{st1}$, $R_{st2}$) jeweils als ein elektromechanisches Potentiometer mit Antrieb, ein schaltbarer Festwiderstand, ein PWM-gesteuerter Halbleiterschalter oder eine analog geregelte Widerstandsnachbildung mit Transistoren ausgeführt sind.

13. Isolationsüberwachungsgerät mit Netzsymmetrierung nach einem der Ansprüche 8 bis 12,
**gekennzeichnet durch**
einen Addierer (10) zur Addition der Leiter-Erde-Spannungen ($U_{DC+, PE}$, $U_{DC-, PE}$) um die Leiter-Leiter-Spannung ($U_{DC+, DC-}$) zu erzeugen oder eine Spannungsmesseinrichtung zur direkten Messung der Leiter-Leiter-Spannung ($U_{DC+, DC-}$).

14. Isolationsüberwachungsgerät mit Netzsymmetrierung nach einem der Ansprüche 8 bis 13,
**gekennzeichnet durch**
eine Auslegung zur Aktivierung der zwei vorgegebenen unterschiedlichen Asymmetriefaktoren ($D_1$, $D_2$) **durch** zyklisches Umschalten symmetrisch um den Symmetriepunkt, wobei die Umschaltzeitpunkte in Abhängigkeit der Regelabweichung (e(t)) steuerbar sind.

**Fig. 1**

Fig. 2

Fig. 3

## EUROPÄISCHER RECHERCHENBERICHT

**Nummer der Anmeldung**

EP 24 20 8118

Europäisches Patentamt
European Patent Office
Office européen des brevets

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A,D | WO 2023/007253 A1 (ABB SCHWEIZ AG [CH]) 2. Februar 2023 (2023-02-02) * Abbildungen 5-17 * * Absatz [0071] - Absatz [0084] * ----- | 1-14 | INV. G01R27/18 G01R31/14 H01G9/21 H01G2/00 |
| A | DE 10 2019 202892 A1 (AUDI AG [DE]) 10. September 2020 (2020-09-10) * Absatz [0011] - Absatz [0015]; Abbildungen 1,2 * * Absatz [0037] - Absatz [0039] * ----- | 1-14 | H01C1/00 G05B11/42 G05B13/02 H01C10/14 H01C10/00 H01C10/50 |
| A | US 2023/283072 A1 (UNRU ALEXANDER [DE] ET AL) 7. September 2023 (2023-09-07) * Absatz [0013] - Absatz [0017] * * Absatz [0033] - Absatz [0039] * ----- | 1-14 | |

**RECHERCHIERTE SACHGEBIETE (IPC)**

G01R
H01G
H01C
G05B
H02M

Der vorliegende Recherchenbericht wurde für alle Patentansprüche erstellt

| Recherchenort | Abschlußdatum der Recherche | Prüfer |
|---|---|---|
| München | 18. März 2025 | Kleiber, Michael |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
.................................................................................
& : Mitglied der gleichen Patentfamilie, übereinstimmendes
    Dokument

EPO FORM 1503 03.82 (P04C03)

# EP 4 549 962 A1

## ANHANG ZUM EUROPÄISCHEN RECHERCHENBERICHT
## ÜBER DIE EUROPÄISCHE PATENTANMELDUNG NR.

EP 24 20 8118

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

18-03-2025

| Im Recherchenbericht angeführtes Patentdokument | Datum der Veröffentlichung | Mitglied(er) der Patentfamilie | | Datum der Veröffentlichung |
|---|---|---|---|---|
| WO 2023007253 A1 | 02-02-2023 | CN | 117941211 A | 26-04-2024 |
| | | EP | 4378046 A1 | 05-06-2024 |
| | | US | 2024326625 A1 | 03-10-2024 |
| | | WO | 2023007253 A1 | 02-02-2023 |
| DE 102019202892 A1 | 10-09-2020 | KEINE | | |
| US 2023283072 A1 | 07-09-2023 | CN | 116547892 A | 04-08-2023 |
| | | DE | 102020129921 A1 | 12-05-2022 |
| | | EP | 4244968 A1 | 20-09-2023 |
| | | JP | 2023549103 A | 22-11-2023 |
| | | US | 2023283072 A1 | 07-09-2023 |
| | | WO | 2022101426 A1 | 19-05-2022 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2023007253 A1
- DE 102020006919 A1

- DE 102018116055 B3